Europäisches Patentamt

European Patent Office

Office européen des brevets

(11) Publication number: **0 498 007 A1**

# EUROPEAN PATENT APPLICATION

(21) Application number: **91101591.5**

(22) Date of filing: **06.02.91**

(51) Int. Cl.5: **G01R 1/067**, G01R 31/302

(43) Date of publication of application:
**12.08.92 Bulletin 92/33**

(84) Designated Contracting States:
**DE FR GB**

(71) Applicant: **International Business Machines Corporation**
**Old Orchard Road**
**Armonk, N.Y. 10504(US)**

(72) Inventor: **Stöhr, Roland R.**
**Kniebisstrasse 2**
**W-7045 Nufringen(DE)**
Inventor: **Probst, Klaus**
**Arlbergstrasse 10**
**W-7033 Herrenberg-Kuppingen(DE)**
Inventor: **Marquart, Bernd**
**Schillerstrasse 32**
**W-7039 Weil im Schönbuch 3(DE)**
Inventor: **Greschner, Johann, Dr.**
**Tiergartenweg 14**
**W-7401 Pliezhausen(DE)**

(74) Representative: **Klocke, Peter, Dipl.-Ing.**
**IBM Deutschland GmbH Patentwesen und**
**Urheberrecht Schönaicher Strasse 220**
**W-7030 Böblingen(DE)**

(54) Method and apparatus for contactless testing.

(57) The method of the present invention allows a complete contactless testing of electric components (4,40,41) including those having a complex wiring structure. For this a rigid set of test electrodes (20, 21) is placed close to the component's surface in a manner that each electrode is positioned next to the corresponding test contact (3) of the component. By applying defined voltages between selected electrodes, glow discharges (5, 51) are generated which are bridging the short distances between the respective terminal electrodes and surface contacts. As the glow discharges will carry electric current it is possible to test wiring defects, e.g. opens or shorts. A variety of test patterns can be applied either subsequently or simultaneously by addressing different test electrodes by means of a programmable pattern generator (13).

FIG. 1

EP 0 498 007 A1

The present invention discloses a method and an apparatus for inspecting electric components. A technique for contactless testing is described which allows examination of components showing different geometric arrangements of sets of surface contacts or test pads. Components comprising a complex internal wiring structure can be completely tested by applying a variety of test patterns either sequentially or simultaneously.

For quality control test equipment plays an essential role in modern production of electric and electronic components. With ongoing development of reducing the outer dimensions of these components, the complexity of the electric wiring structure and the density of surface contacts per unit area increases. Thus each test piece requires a whole set of test patterns which must be applied via a plurality of surface contacts.

Standard methods use test devices wherein all test points on the surface of the inspected component are contacted simultaneously by a set of metallic test needles under spring tension. Herein the set of needles is geometrically arranged to correspond to the respective surface contacts or test dots of the examined component, and is fixed by a base ring or socket thus providing a rigid probe unit. As each different type or modification of the tested components requires its own specific set of test needles, a renewal of test equipment parts (probe unit) is necessary after product changes, which is time and cost consuming.

Modern products in this field, e.g. ceramic substrates for integrated circuits, carry up to several ten thousands of surface contacts. To give secure electrical contact to the respective set of test needles a contact pressure is necessary which can easily sum up to a very high level (about 10.000 N). This results in an extreme mechanical stress of the test piece, which in some cases might lead to partial damaging.

An alternative testing method uses only a few number of test needles, which are not fixed as a rigid unit, but can be moved by a high accuracy positioning mechanism. Hereby different surface test points are contacted subsequently which results in a time consuming sequence of placing steps. For test pieces like the mentioned ceramic substrate, having large numbers of contact points, such a test sequence will take up to several hours. Besides this, due to the frequent repetition of resetting the test needles, the tips of the needles are subjected to enhanced attrition and must be replaced in short intervals.

Another, specific method is the E-beam testing, which allows measurement of voltage values at different places on the test piece surface without test needle contacting. For this the investigated component is placed into the vacuum chamber of an electron microscope (SEM) and scanned by an electron beam. The whole surface or part of it can be viewed on screen, whereby local variations of potential levels on the surface of the component, e.g. at different metal lines, are detected and shown by intensity contrast. As it is not possible to generate defined test voltages by the electron beam itself, it is necessary to apply all of the desired bias voltages by separate contacts, e.g. by metal needles. Thus E-beam testing requires at least a higher expenditure as standard testing methods and is therefore, not likely used for quality control in plant mass production.

The present invention is intended to remedy these drawbacks.

Modern components usually comprise a complex wiring structure. Full inspection thus requires a variety of test patterns, comprising addressing of individual contacts of the tested component. Test cycles typically include sequences of voltage or current switching or ramping, which were applied to - and correspondingly picked up from - actually selected surface contacts of the tested component. Hereby the component can be regarded as part of an electric circuit. Contactless testing therefore must ensure electric current flow.

The inventive technique as claimed solves this apparent contradiction and delivers a technique which allows the inspection of electric components without the need of direct and mechanically performed contacting by the use of localized glow discharges which serve as ionic conduction paths between the examined component and the testing apparatus. Glow discharges are able to bridge distances in the range of about 30 to 80 microns and can be generated under different conditions. The glow discharge itself consists of ions of gas atoms or molecules, thus the surrounding atmosphere is of essential influence. Besides air other gases or mixtures are appropriate. Especially noble gases or mixtures thereof, e.g. the "Penning mixture" consisting of 99.9% Ne and 0.1% Ar, are known in the art as being suitable for generating glow discharges. The partial pressure hereby basically determines the maximum distance which can be bridged by the glow discharge and is preferably reduced to a level of about 5 to 50 kPa. Another factor which mainly influences this maximum distance is the actual potential difference of the corresponding pair of electrodes between which the glow discharge occurs. The value of the potential difference which is capable to initialize the discharge is known as "critical voltage". Voltages in the range of 30 to 250 V are sufficient to bridge the mentioned distances whereby a nearly linear relationship between both values exists. All factors - potential difference, pressure and electrode spacings - are combined in the scientific principle known as Paschen's Rule, which allows the calculation of desired parameters. The current flow via the glow discharges mainly depends on the selected conditions and can reach values up to several mA.

Modern electric components typically carry a plurality of surface contacts which can be of different types. E.g. substrates for integrated circuits may comprise small metallic areas for wire bondings, or solder balls for the well known C4-bonding technique. In many cases these substrates in addition carry on their backside an array of pins for plugging the substrate into larger boards or panels.

The inventive method is capable of testing pieces showing various types of surface contacts, as the glow discharge effect is not restricted to a special geometric shape of the contacts. However tapered or hollow electrodes will reduce the 'critical voltage' due to the enhanced density of the electric field on the tip or edge. Thus the terminal electrodes of the testing apparatus can be formed, for example, by etching techniques to have a conical or a concave shape respectively. As current is transported via these electrodes, they are consisting of or covered with conducting material, e.g. metal, alloys or doped semiconductor.

Preferably the terminal electrodes are arranged as a standardized array and form a rigid terminal probe unit. This unit is held, for example, by a clamp or plug-in mechanism as a fixed part of the test device. The tested component is then placed close to the probe unit with it's surface aligned to be collateral to the plane of the terminal electrodes by means of a positioning mechanism. The distance between each terminal electrode and the corresponding surface contact of the inspected component should be less than the spacings between terminal electrodes and the spacings between surface contacts, respectively. For a test arrangement with glow discharges bridging, e.g. a distance of about 50 microns spacings between terminal electrodes or surface contacts should have a value of about 60 microns or greater.

It is a specific advantage of the disclosed method that no very high precision positioning of the tested component with respect to the terminal probe unit is necessary if no next neighbored terminal electrodes are addressed simultaneously. Each glow discharge will only occur between terminal electrodes and corresponding surface contacts which show potentials of different levels. A small lateral displacement, i.e. considerably less than half the spacings between next neighbored surface contacts, has only a minor influence by enlarging the distance between terminal electrode and respective surface contact. This 'self-aligning' effect in some cases can be enhanced by giving electrodes being next neighbored to the selected one a reversal potential, thus preventing generation of undesired glow discharges.

Usually the primary function of substrates for integrated circuits is interwiring and providing electric connection to peripheral components. Thus they typically comprise a complex internal network or wiring structure. During inspection process each conduction line must be electrically tested, to detect malfunction caused, for example, by shorts or opens. This requires the selection of different sets of corresponding surface contacts during each investigation process. A very quick addressing of the respective terminal electrodes of the probe unit can be performed by means of a programmable pattern generator which is connected to at least one array of terminal electrodes. This allows a fast sequencing of determined test steps which can easily be modified by standard programming techniques. Actual current flow in selected conduction lines can be monitored simultaneously and converted to data for computer analysis.

It is a special advantage of the disclosed technique that different types or modifications of tested components can be examined without major alterations of the test apparatus. For this the set of terminal test electrodes of the probe unit is arranged as a standardized array and a space transformer serving as an adapter is interposed between the test electrodes and the surface of the inspected component. The space transformer or interposer itself is construed as an interwiring structure, having paired surfaces and respective electrode arrangements thereon fitting on the one hand to the surface and set of electrodes of the tested component, and on the other to the standardized array of electrodes of the testing apparatus. Thus electric currents are transferred by chains of glow discharges occurring between selected terminal electrodes, the respective contacts of the interposer, and the corresponding surface contacts of the inspected component. Components which carry contacts on their front and back surfaces can be tested by transferring signals via glow discharges to a second set or array of terminal electrodes of the test apparatus, whereby a second space transformer can be used optionally. Space transformers are consisting of isolating or semiconductor material, e.g. ceramics, glasses, glass-ceramics, silicon or composition material. As they serve as an interwiring structure they may comprise a stack of layers carrying conduction lines, which are vertically interconnected through respective openings or vias.

It is another advantage of the invention that due to the completely contactless testing procedure no mechanical stresses occur during test cycles. Accordingly damaging of inspected components is avoided.

For a better understanding of the present invention, together with further objects and advantages, a preferred embodiment of the invention is described in the following with reference to the accompanying drawings of which:

Figure 1 is a scheme of a preferred embodiment of the testing apparatus having a tight housing wherein the component is tested under the desired conditions. The testing environment includes a test pattern generator addressing a switching unit. This unit selects various combinations of terminal electrode pairs which were accordingly biased with the desired voltages provided by the respective power supply unit. Actual voltages and resulting currents are detected by means of a measuring unit which is sending all data to the central control unit;

Figure 2 shows glow discharges occurring between terminal electrodes and surface contacts of one side of a component having an interwiring structure;

Figure 3 demonstrates the function of a space transformer interposed between terminal electrode array and the tested component; and

Figure 4 displays another possible path of a test current if the inspected component comprises additional backside contacts and a second set of terminal electrodes is used.

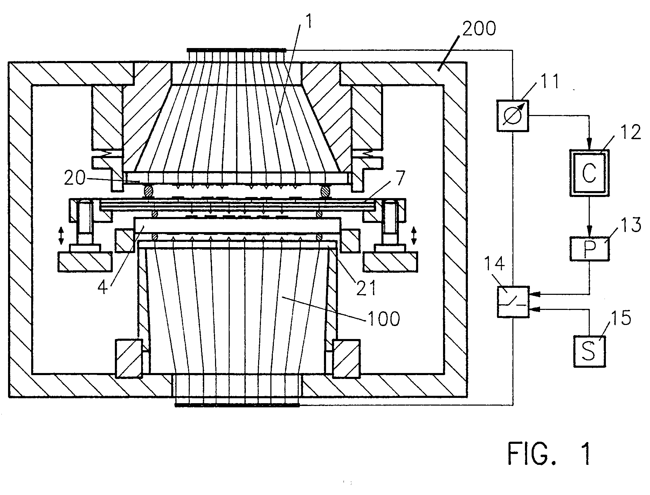

The preferred embodiment of the invention as shown in FIG.1 comprises a tight probe chamber 200, wherein the component 4 is tested under the desired conditions, e.g. noble gas atmosphere having reduced partial pressure. The inspected component 4 carries surface contacts on it's front and back side and is positioned with one side being adjacent to a space transformer 7 and the other facing a first set of terminal electrodes or probe unit 21. The space transformer is interposed between the component and a second set of terminal electrodes 20. It comprises a multi layer interwiring structure thus conducting electrodes of the component facing side with the corresponding electrodes of the surface next to the probe unit 20. Each set of terminal electrodes is connected via bundles of wirings 1, 100 to the peripheral equipment of the testing apparatus. A computer 12 serves as a central unit controlling a pattern generator 13 and receiving data from a measuring unit 11. The pattern generator addresses a switching unit 14 which biases the selected terminal electrodes to a desired variety of voltage levels applied by a power supply unit 15. If ramping of voltages or currents is part of the test cycles, the power supply 15 may additionally be controlled directly by the central unit 12.

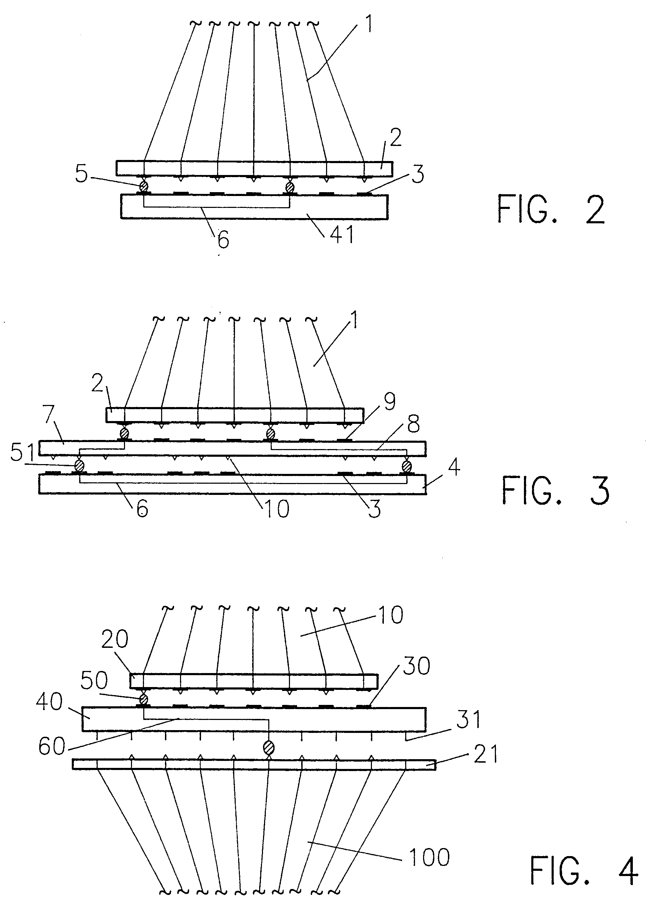

For testing of components 41 which carry contacts 3 merely on their front side only one set of terminal electrodes 2 will be sufficient. FIG. 2 shows a respective component under inspection wherein specifically no space transformer is used due to the fact that the arrangement of the surface contacts 3 fits to the set of terminal electrodes 2. In this case pairs of glow discharges 5 occur, localized with respect to the terminal electrodes which are selected to correspond to the surface contacts of one of the conducting lines 6 of the tested component.

FIG. 3 represents the equivalent case but with the difference of non-compatible arrangements of terminal electrodes and surface contacts. During inspection a space transformer 7 is interposed between the probe unit 2 and the tested component, comprising corresponding sets of surface electrodes 9, 10. Each surface electrode on one side of the space transformer is electrically connected by a wiring line 8 to the respective electrode on the other side. Test currents are then transferred by chains of glow discharges 5, 51.

Modern electric components, especially multi layer interwiring substrates typically comprise different types of surface contacts. FIG. 4 shows testing of a component 40 comprising two different sets of contacts 30, 31 on front and back side respectively. In the presented situation two sets of terminal electrodes 20, 21 are used which are directly fitting to the contact arrangement of the facing sides of the component. For standardized sets of terminal electrodes which are not meeting the surface layout of the inspected component one or two space transformers can be used for transferring the test signals (not shown). Multi layer substrates or other components which carry on their backside contact pins 31 can be alternatively tested by replacing the second set of terminal electrodes 21 by a respective plug-in socket (not shown).

## Claims

1. Method for contactless electrical testing of components (4,40,41) which comprise at least two contact means (3,30) exposed on their surface wherein

   test currents are applied to said components via gas glow discharges (5,50,51) induced by means of at least one set of terminal electrodes (2,20,21).

2. The method according to claim 1 wherein said inspected components are interposed between at least two sets of said terminal electrodes.

3. The method according to claim 1 or 2 wherein said gas glow discharges are generated by voltages in the range of 30 to 250 volts.

4. The method according to any one of the preceding claims wherein said gas glow discharges takes place in an atmosphere consisting of air or noble gas or a mixture thereof.

5. The method according to any one of the preceding claims wherein said gas glow discharge takes place in an atmosphere consisting of a mixture of noble gases, preferably comprising 99.9% Ne and 0.1% Ar.

6. The method according to claim 4 or 5 wherein said atmosphere has a partial pressure in the range of 5 to 50 kPa.

7. The method according to any one of the preceding claims wherein diverse test currents of individual level are applied subsequently or simultaneously.

8. The method according to any one of the preceding claims, wherein a sequence of current test patterns is applied to said inspected components by means of a test pattern generator (13).

9. An apparatus for contactless testing of components according to the method as recited in any one of the preceding claims wherein each of said at least one set of terminal electrodes comprises an array of terminal electrodes.

10. An apparatus according to claim 9 wherein said terminal electrodes have a tapered or concave shape.

11. An apparatus according to claim 9 or 10 wherein said terminal electrodes consist of or are covered with metal, alloy or doped semiconductor.

12. An apparatus according to claim 9, 10 or 11 including additional space transforming means (7) interposed between said inspected devices and said at least one set of said terminal electrodes.

13. An apparatus according to claim 12 wherein said space transforming means comprise paired sets of surface electrodes (9,10) which are arranged to correspond on the one hand to said contact means (3,30) exposed on said inspected components and on the other to said at least one set of said terminal electrodes.

14. An apparatus according to claim 12 or 13 wherein said space transforming means comprise an interwiring structure (8) for interconnecting said surface electrodes of said paired sets.

15. An apparatus according to claim 12, 13 or 14 wherein said space transforming means are basically consisting of an isolating or a semiconducting material, preferably selected from ceramics, glasses, glass-ceramics, silicon or composition material.

FIG. 1

FIG. 2

FIG. 3

FIG. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| E | WO-A-9102986 (SIEMENS)<br>* abstract *<br>* page 2, lines 24 - 26 *<br>* page 2, lines 30 - 35 *<br>* page 3, lines 5 - 9 *<br>* page 3, line 29 - page 4, line 7 *<br>* page 4, lines 12 - 17 *<br>* page 3, lines 14 - 18 *<br>--- | 1-15 | G01R1/067<br>G01R31/302 |
| A | FR-A-2524649 (THOMSON-CSF)<br>* page 9, line 28 - page 10, line 2; figure 3 *<br>--- | 12-15 | |
| X | EP-A-102565 (SIEMENS)<br>* abstract; claims 1, 2 *<br>* page 2, lines 6 - 7 *<br>* page 2, lines 31 - 34 *<br>* page 3, lines 10 - 12 *<br>--- | 1, 7, 9 | |
| X | EP-A-322607 (SIEMENS)<br>* abstract *<br>----- | 1, 9 | |
| | | | TECHNICAL FIELDS SEARCHED (Int. Cl.5 )<br><br>G01R |

The present search report has been drawn up for all claims

| Place of search | Date of completion of the search | Examiner |
|---|---|---|
| BERLIN | 09 OCTOBER 1991 | FRITZ S. |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

    & : member of the same patent family, corresponding
document

EPO FORM 1503 03.82 (P0401)